# FASCICULE DE BREVET EUROPEEN

(11) **EP 4 455 798 B1**
(45) Date de publication et mention de la délivrance du brevet: **18.02.2026**
(21) Numéro de dépôt: 23170798.5
(22) Date de dépôt: 28.04.2023
(51) Int. Cl.: G04B 19/12, C23C 14/00, C23C 16/00, G04B 37/22, G04B 45/00, G04D 3/00, A44C 27/00, G04B 39/00

(54) **PIÈCE D'HABILLAGE EN MATÉRIAU CÉRAMIQUE COMPRENANT UN REVÊTEMENT DE PROTECTION ET PROCÉDÉ DE RÉALISATION D'UNE TELLE PIÈCE D'HABILLAGE**
VERKLEIDUNGSTEIL AUS KERAMISCHEM MATERIAL MIT EINER SCHUTZSCHICHT UND VERFAHREN ZUR HERSTELLUNG EINES SOLCHEN VERKLEIDUNGSTEILS
TRIM PART MADE OF CERAMIC MATERIAL COMPRISING A PROTECTIVE COATING AND METHOD FOR PRODUCING SUCH A TRIM PART

(43) Date de publication de la demande: 30.10.2024
(73) Titulaire: The Swatch Group Research and Development Ltd, 2074 Marin (CH)
(72) Inventeur: CURCHOD, Loïc, 1004 Lausanne (CH); SPASSOV, Vladislav, 1788 Praz (CH); TABARD, Lucie, 2000 Neuchâtel (CH); FORNABAIO, Marta, 1023 Crissier (CH)
(74) Mandataire: ICB SA

(56) Documents cités:
- EP-A1- 4 001 458
- CH-A1- 709 669
- CH-A2- 718 382
- CH-A2- 718 459
- US-B1- 6 503 557

## Description

### Domaine technique de l'invention

L'invention relève des articles décoratifs dans les domaines de l'horlogerie, de la bijouterie ou de la joaillerie ou des articles de mode, et concerne plus particulièrement une pièce d'habillage en matériau céramique comprenant un revêtement de protection et un procédé de réalisation d'une telle pièce d'habillage.

Dans le présent texte, les termes « pièce d'habillage » désignent, de façon communément admise dans les domaines précités, une pièce visible pour un utilisateur, et ayant une fonction notamment décorative.

Par ailleurs, les articles de mode comprennent les articles ou accessoires d'habillement, tels que les ceintures, chaussures, vêtements, etc., et comprennent en outre les instruments d'écriture, les articles de lunetterie, de maroquinerie, de téléphonie, ou tout objet décoratif.

### Arrière-plan technologique

Dans le domaine de l'horlogerie, plusieurs solutions ont été développées pour protéger d'agressions chimiques et/ou mécaniques, qui peuvent modifier l'aspect ou la couleur, les pièces d'habillage en céramique, telles que les cadrans, rehauts, lunettes, carrures, couronnes, poussoirs, maillons, etc.

A titre d'exemple, les pièces d'habillage peuvent comporter une couche mince de protection déposée par une méthode de dépôt sous vide, telle qu'une méthode de dépôt PVD (pour Physical Vapor Deposition en langue anglaise), une méthode de dépôt CVD (pour Chemical Vapor Deposition en langue anglaise) ou une méthode de dépôt ALD (pour Atomic Layer Deposition en langue anglaise).

Toutefois, aucune solution de l'état de l'art ne donne entière satisfaction. En effet, aucune couche de protection de l'état de l'art ne présente une faible épaisseur, par exemple inférieure à 5 µm, tout en étant parfaitement transparente, c'est-à-dire en n'absorbant pas, dans la plage visible du spectre lumineux, une partie du rayonnement lumineux incident, ne donnant pas de couleurs interférentielles et en présentant une résistance appropriée aux agressions chimiques et mécaniques, comme le montrent les documents CH709669A1 et CH718459A2 par exemple.

Il y a lieu de noter que les couches minces déposées par les méthodes de dépôt ALD présentent des avantages par rapport aux couches minces déposées par les méthodes de dépôt PVD et CVD. En effet, ces couches minces ALD sont très efficaces pour protéger le substrat des agressions chimiques, et du fait de leur faible épaisseur, sont invisibles à l'œil nu de sorte qu'elles n'impactent pas l'aspect visuel du substrat qu'elles recouvrent.

Cependant, en étant très minces, ces couches sont très sensibles aux contraintes mécaniques, par exemple aux frottements ou aux chocs. Elles ne peuvent donc pas être utilisées pour recouvrir des pièces d'habillage susceptibles d'entrer en contact avec des éléments extérieurs, telles que la lunette ou la carrure d'une montre.

Les couches présentant une épaisseur plus élevée que celle des couches minces ALD, typiquement de l'ordre du micron, offrent une résistance plus importante aux contraintes mécaniques. Toutefois, ces couches sont visibles sur le substrat et ne répondent donc pas aux exigences si l'aspect visuel du substrat doit être préservé, notamment pour des raisons décoratives.

Il existe donc un besoin de disposer d'une solution de protection efficace contre les agressions chimiques et mécaniques, et adaptée pour préserver l'aspect visuel du substrat ainsi protégé.

### Résumé de l'invention

L'invention résout les inconvénients précités et concerne, à cet effet, une pièce d'habillage, préférentiellement d'une montre, comprenant un substrat réalisé en matériau céramique sur une surface duquel s'étend un revêtement de protection inorganique transparent. Le revêtement est configuré de sorte à présenter un indice de réfraction, au moins à l'interface avec le substrat, sensiblement égal à celui du substrat pour les longueurs d'onde dans le domaine visible du spectre lumineux de sorte à ce qu'il ne génère pas de phénomène d'interférences, ou très peu, c'est-à-dire sensiblement non visibles à l'œil nu, et que la pièce d'habillage présente une couleur sensiblement identique à la couleur intrinsèque du substrat.

Aussi, le revêtement présente une épaisseur relativement faible, ce qui permet de générer une économie de temps de dépôt et de coûts de production de la pièce d'habillage, tout en étant suffisamment élevée pour lui conférer une bonne résistance mécanique à l'abrasion et une bonne protection contre les agressions chimiques. En particulier, l'épaisseur du revêtement est comprise entre 300 nm et 5 µm. Le revêtement peut présenter avantageusement une dureté élevée, typiquement une dureté Vickers de l'ordre de 25 GPa.

L'invention permet ainsi de protéger la pièce d'habillage tout en lui permettant de conserver la couleur intrinsèque du substrat.

Dans des modes particuliers de réalisation, l'invention peut comporter en outre l'une ou plusieurs des caractéristiques suivantes, prises isolément ou selon toutes les combinaisons techniquement possibles.

Dans des modes particuliers de réalisation, le revêtement de protection est configuré de sorte qu'il confère à la pièce d'habillage une couleur dont la différence avec la couleur intrinsèque du substrat est caractérisée par Delta E ≤ 10 dans l'espace colorimétrique L*a*b*.

Dans des modes particuliers de réalisation, le revêtement de protection est configuré de sorte qu'il confère à la pièce d'habillage une couleur dont la différence avec la couleur intrinsèque du substrat est caractérisée par Delta E ≤ 5 dans l'espace colorimétrique L*a*b*.

Dans des modes particuliers de réalisation, l'épaisseur du revêtement de protection est comprise entre 300 nm et 1 µm.

Dans des modes particuliers de réalisation, le revêtement de protection est formé d'au moins deux composés présentant respectivement, pour les longueurs d'onde dans le domaine visible du spectre lumineux, un indice de réfraction supérieur à celui du substrat et un indice de réfraction inférieur à celui du substrat. Le contrôle de la proportion de chaque composé dans la composition du revêtement de protection permet alors de maitriser finement l'indice de réfaction du revêtement de protection de sorte qu'il soit sensiblement égal à l'indice de réfraction du substrat et supprime ainsi tout phénomène d'interférence.

Dans des modes particuliers de réalisation, le revêtement de protection comporte au moins une couche réalisée en TiₓAl_{y}O_{z}.

Dans des modes particuliers de réalisation, le revêtement de protection comporte au moins une couche réalisée en SiₓO_{y}N_{z}.

Dans des modes particuliers de réalisation, le substrat peut être réalisé en oxyde, nitrure, carbure, carbonitrure, borure, notamment en alumine Al₂O₃, en zircone ZrO₂ ou en composite alumine-zircone.

Selon un autre aspect, la présente invention concerne en outre, un procédé de fabrication d'une pièce d'habillage par exemple telle que décrite précédemment, comprenant les étapes de préparation d'une surface d'un substrat, et de dépôt d'un revêtement de protection inorganique transparent sur ladite surface par une méthode de dépôt sous vide, en atmosphère réactive ou non-réactive.

L'étape de dépôt est réalisée à partir d'au moins une source d'au moins un matériau choisi de sorte que le revêtement de protection présente un indice de réfraction sensiblement égal à celui du substrat dans le domaine visible du spectre lumineux, ladite étape étant en outre réalisée de sorte que le revêtement de protection présente une épaisseur comprise entre 300 nm et 5 µm, pour qu'il résiste aux agressions mécaniques et chimiques.

Dans des modes particuliers de mise en œuvre, l'étape de dépôt d'un revêtement de protection est réalisée par méthode de pulvérisation cathodique.

Dans des modes particuliers de mise en œuvre, le revêtement de protection est déposé à partir d'au moins deux sources de matériaux différents, lesdits matériaux étant choisis de sorte que lors de l'étape de dépôt, ils forment chacun un composé présentant, dans le domaine visible du spectre lumineux, respectivement un indice de réfraction supérieur à celui du substrat et un indice de réfraction inférieur à celui du substrat. La puissance de pulvérisation de chacune des sources est contrôlée de sorte que les proportions de chaque composé dans le revêtement de protection sont telles que ledit revêtement présente un indice de réfraction sensiblement identique à celui du substrat.

Dans des modes particuliers de mise en œuvre, le revêtement de protection est déposé à partir d'au moins une source d'un mélange d'au moins deux matériaux, lesdits matériaux étant choisis de sorte que lors de l'étape de dépôt, ils forment chacun un composé présentant, dans le domaine visible du spectre lumineux, respectivement un indice de réfraction supérieur à celui du substrat et un indice de réfraction inférieur à celui du substrat. La source est préparée de sorte à comporter des proportions prédéfinies desdits matériaux de sorte que le revêtement de protection présente, à l'issue de l'étape de dépôt, un indice de réfraction sensiblement identique à celui du substrat.

Dans des modes particuliers de mise en œuvre, les matériaux choisis sont de l'Al et du Ti, l'étape de dépôt étant mise en œuvre en utilisant de l'O₂ comme gaz réactif de sorte qu'à l'issu de l'étape de dépôt, le revêtement de protection comprenne un mélange de TiO₂ et d'Al₂O₃ de sorte à former un composé du type TiₓAl_{y}O_{z}.

Dans des modes particuliers de mise en œuvre, le revêtement de protection est déposé à partir d'au moins une source d'un unique matériau choisi de sorte que, lors de l'étape de dépôt, il forme plusieurs composés en réagissant avec plusieurs gaz réactifs en présence. Les composés présentent, dans le domaine visible du spectre lumineux, respectivement un indice de réfraction supérieur à celui du substrat et un indice de réfraction inférieur à celui du substrat, les gaz réactifs étant présents dans des proportions prédéfinies de sorte que le revêtement de protection présente, à l'issue de l'étape de dépôt, un indice de réfraction sensiblement identique à celui du substrat.

Dans des modes particuliers de mise en œuvre, l'étape de dépôt est effectuée à partir d'une source réalisée en Si et en utilisant de l'O₂ et de l'N₂ comme gaz réactifs de sorte qu'à l'issu de l'étape de dépôt, le revêtement de protection comprenne un mélange de SiO₂ et de Si₃N₄ de sorte à former un composé du type SiₓO_{y}N_{z}.

### Brève description des figures

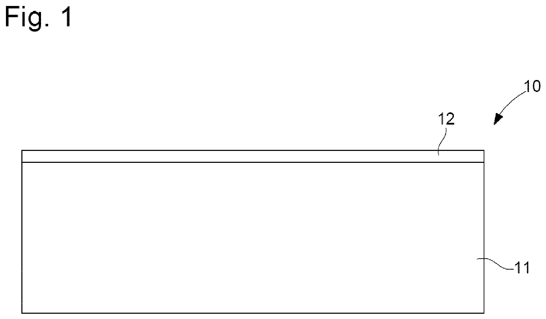

D'autres caractéristiques et avantages de l'invention apparaîtront à la lecture de la description détaillée suivante donnée à titre d'exemple nullement limitatif, en référence à la figure 1 représentant schématiquement une vue en coupe transversale d'une pièce d'habillage selon un exemple préféré de réalisation de l'invention.

On note que la figure n'est pas nécessairement dessinée à l'échelle pour des raisons de clarté.

### Description détaillée de l'invention

L'invention concerne une pièce d'habillage 10, telle que représentée schématiquement sur la figure 1. La pièce d'habillage 10 selon l'invention est adaptée aux domaines de l'horlogerie, de la bijouterie, de la joaillerie, des articles de mode, etc. Préférentiellement, la pièce d'habillage 10 est destinée à former un cadran de montre, une carrure, une lunette, un bracelet ou tout autre composant d'horlogerie visible pour un utilisateur.

La pièce d'habillage 10 comprend un substrat 11 diélectrique, par exemple réalisé en matériau céramique, tel qu'en alumine Al₂O₃, ou zircone ZrO₂ ou en composite alumine-zircone, avec ou sans pigments colorant ledit substrat. La pièce d'habillage 10 comporte en outre un revêtement de protection 12 inorganique transparent s'étendant sur une surface du substrat 11 destinée à être visible par un utilisateur.

Il y a lieu de noter que le terme « transparent » désigne dans le présent texte la capacité d'un matériau à ne pas absorber la lumière de façon visible à l'œil humain.

Le revêtement de protection 12 peut être formé par une unique couche mince ou par un plusieurs couches minces.

Avantageusement, le revêtement de protection 12 permet de protéger le substrat 11 contre les agressions chimiques, notamment générées par l'humidité, les gaz soufrés, l'oxygène et les milieux acides. En outre, le revêtement de protection 12 est dimensionné de sorte à résister aux contraintes mécaniques, notamment générées par les frottements ou les chocs.

A cette fin, le revêtement de protection 12 s'étend sur une épaisseur choisie, par exemple, entre 300 nm et 5 µm, plus particulièrement entre 300 nm et 1 µm. Préférentiellement, l'épaisseur du revêtement de protection 12 est égale à 1 µm.

Le revêtement de protection 12 est configuré de sorte à présenter un indice de réfraction sensiblement égal à celui du substrat 11 dans le domaine visible du spectre lumineux, au moins à l'interface avec ledit substrat 11. Dans le présent texte, l'indice de réfraction du revêtement de protection 12 est sensiblement égal à celui du substrat 11 dans la mesure où il est compris dans un intervalle de plus ou moins cinq pourcents par rapport à la valeur de ce dernier.

Ces caractéristiques permettent avantageusement au revêtement de protection 12 de ne pas produire ou de produire très peu d'interférences optiques, et donc permettent à la pièce d'habillage 10 protégée par la couche 12 de présenter la couleur intrinsèque du substrat 11. Il y a lieu de noter que les éventuelles interférences produites sont tellement faibles qu'elles ne sont pas visibles pour un utilisateur et sont donc négligeables.

La notion de « couleur intrinsèque » fait référence, dans le présent texte, à la couleur du substrat 11 sans revêtement telle qu'elle est perçue par un utilisateur lorsqu'il est éclairé par une lumière blanche, du fait du ou des matériaux qui le composent. Ainsi, le revêtement de protection 12 n'est pas visible à l'œil nu dans le sens où la pièce d'habillage 10 présente sensiblement la même couleur avec ou sans revêtement de protection 12 déposé sur le substrat 11.

Plus précisément, le revêtement de protection 12 est configuré de sorte qu'il confère à la pièce d'habillage 10 une couleur dont la différence avec la couleur intrinsèque du substrat 11 est caractérisée par Delta E ≤ 10 dans l'espace colorimétrique L*a*b*, et plus particulièrement Delta E ≤ 5.

En résumé, grâce aux caractéristiques de l'invention, la pièce d'habillage 10 comporte une protection chimique du substrat 11 tout en conservant l'aspect esthétique et la tenue mécanique de ce dernier.

Préférentiellement, le revêtement de protection est formé d'au moins deux composés présentant respectivement, pour les longueurs d'onde dans le domaine visible du spectre lumineux, un indice de réfraction supérieur à celui du substrat 11 et un indice de réfraction inférieur à celui du substrat 11.

Par exemple, le revêtement de protection 12 peut comporter un mélange de TiO₂, qui présente un indice de réfraction élevé, et de Al₂O₃, qui présente un indice de réfraction bas. Il y a lieu de noter que cet exemple de revêtement de protection 12 n'est pas compatible avec un substrat 11 qui serait réalisé dans une matière dont l'indice de réfraction est inférieur à celui d'un revêtement d'Al₂O₃ seul ou supérieur à celui d'un revêtement de TiO₂ seul.

Alternativement, le revêtement de protection 12 peut comporter un mélange de Si₃Ni₄, qui présente un indice de réfraction élevé, et de SiO₂, qui présente un indice de réfraction bas.

De manière plus générale, pour résumer, le revêtement de protection 12 peut comporter au moins une couche mince réalisée en TiₓAl_{y}O_{z} ou en SiₓO_{y}N_{z}.

La présente invention concerne également un procédé de fabrication d'une pièce d'habillage 10, par exemple de la pièce d'habillage 10 telle que précédemment décrite. Le procédé comprend les étapes de préparation de la surface du substrat 11 destinée à être visible pour un utilisateur, et de dépôt du revêtement de protection 12 sur ladite surface par une méthode de dépôt sous vide.

L'étape de préparation peut consister à polir le substrat 11, le sabler, le brosser, le satiner, ou à effectuer toute autre opération de préparation de surface.

L'étape de dépôt est réalisée en employant une ou des sources de matériaux dont la composition est choisie de sorte à former un revêtement de protection 12 présentant un indice de réfraction sensiblement égal à celui du substrat 11 dans le domaine visible du spectre lumineux.

Cette étape de dépôt est en outre réalisée de sorte à déposer le revêtement de protection 12 afin qu'il présente une épaisseur telle qu'il résiste aux agressions mécaniques, notamment à l'abrasion, et aux agressions chimiques, tel que décrit précédemment.

Par ailleurs, le procédé peut comporter une étape préliminaire de préparation d'au moins une source de matériau employée lors de l'étape de dépôt. L'étape de préparation des sources permet par exemple d'adapter le type de source approprié selon la méthode de dépôt sous vide utilisée lors de l'étape de dépôt et d'adapter la proportion de matériaux de la source lorsqu'elle en comporte plusieurs afin d'obtenir le revêtement de protection 12 souhaité. Le type de source de matériau varie suivant la méthode de dépôt sous vide utilisée, dans la mesure où, la source est une cible sous forme solide si la méthode de dépôt utilisée est une méthode de dépôt physique en phase vapeur PVD, et la source est un précurseur en phase gazeuse si la méthode de dépôt utilisée est une méthode de dépôt chimique en phase vapeur CVD ou une méthode de dépôt de couches atomiques ALD.

Dans une variante de mise en œuvre du procédé, le revêtement de protection 12 est déposé à partir d'au moins deux sources de matériaux différents, par exemple de matériaux métalliques différents. Lesdits matériaux sont choisis de sorte que, lors de l'étape de dépôt, ils forment chacun un composé, par exemple un oxyde, un nitrure ou un carbure, lesdits composés présentant, dans le domaine visible du spectre lumineux, respectivement un indice de réfraction supérieur à celui du substrat 11 et un indice de réfraction inférieur à celui du substrat 11. Lors de l'étape de dépôt, en contrôlant la puissance de pulvérisation de chacune des sources, la proportion de chaque composé déposé pour constituer le revêtement de protection 12 est maitrisé de sorte que ce dernier présente l'indice de réfraction souhaité. Cet indice de réfraction souhaité du revêtement de protection 12 est sensiblement identique à celui du substrat 11, comme décrit ci-dessus.

Par exemple, l'un des matériaux peut être de l'Al et l'autre peut être du Ti. L'étape préliminaire de préparation est alors mise en œuvre de sorte à obtenir deux sources dont une est réalisée en Ti et l'autre en AI, et l'étape de dépôt est mise en œuvre en utilisant de l'O₂ comme gaz réactif. Dans cet exemple, à l'issue de l'étape de dépôt, le revêtement de protection 12 est alors formé d'un mélange de TiO₂ et d'Al₂O₃. Ces deux oxydes métalliques présentant respectivement un indice de réfraction supérieur et inférieur à celui du substrat 11, contrôler leur proportion dans le revêtement de protection 12 permet de maitriser l'indice de réfraction du revêtement 12.

Dans une autre variante de mise en œuvre du procédé, le revêtement de protection 12 est déposé à partir d'au moins une source d'un mélange d'au moins deux matériaux. Lesdits matériaux sont également choisis de sorte que, lors de l'étape de dépôt, ils forment chacun un composé, par exemple un oxyde, un nitrure, un borure ou un carbure, lesdits composés présentant, dans le domaine visible du spectre lumineux, respectivement un indice de réfraction supérieur à celui du substrat 11 et un indice de réfraction inférieur à celui du substrat 11. Lors de l'étape préliminaire, la source est préparée de sorte à comporter des proportions prédéfinies desdits matériaux de sorte à maitriser la composition du revêtement de protection 12 déposé pour que ce dernier présente, à l'issue de l'étape de dépôt, l'indice de réfraction souhaité.

Par exemple, il est envisageable que l'étape préliminaire de préparation soit mise en œuvre de sorte à obtenir une source d'un mélange de Ti et Al, et que l'étape de dépôt soit mise en œuvre en utilisant de l'O₂ comme gaz réactif. Dans cet exemple, à l'issue de l'étape de dépôt, le revêtement de protection 12 est alors composé d'un mélange de TiO₂ et d'Al₂O₃. De la même manière que dans la variante de mise en œuvre précédente, ces deux oxydes métalliques présentant respectivement un indice de réfraction supérieur et inférieur à celui du substrat 11, le contrôle de leur proportion dans le revêtement de protection 12 permet de maitriser l'indice de réfraction du revêtement 12 de sorte qu'il soit sensiblement égal à celui du substrat 11. La source étant préparée en amont avec les proportions prédéfinies de chaque matériau, cette variante est plus adaptée pour mettre en œuvre le procédé de façon industrielle, de manière simple, rapide et stable.

Dans encore une autre variante de mise en œuvre du procédé, le revêtement de protection 12 peut être déposé à partir d'au moins une source d'un unique matériau choisi de sorte que, lors de l'étape de dépôt, selon les gaz réactifs utilisés, tel que l'O₂ ou le N₂, il forme différents composés. Les composés présentent, dans le domaine visible du spectre lumineux, respectivement un indice de réfraction inférieur à celui du substrat 11 et un indice de réfraction supérieur à celui du substrat 11. Ainsi, en contrôlant la quantité de chaque gaz en présence lors de l'étape de dépôt, la stœchiométrie des composés constituant le revêtement de protection 12 est maitrisée de sorte à obtenir l'indice de réfraction souhaité du revêtement de protection 12.

Par exemple, l'étape préliminaire de préparation peut être mise en œuvre de sorte à obtenir une source en Si, et l'étape de dépôt peut être mise en œuvre en utilisant du N₂ et de l'O₂ comme gaz réactifs. Dans cet exemple, à l'issue de l'étape de dépôt, le revêtement de protection 12 est composé d'un mélange de SiO₂ et de Si₃N₄**.** Le mélange entre un oxyde métallique et un nitrure du même métal dans des proportions contrôlées permet donc de maitriser l'indice de réfraction du revêtement 12 de sorte qu'il soit sensiblement identique à celui du substrat 11.

Ces différentes variantes de mise en œuvre permettent avantageusement d'obtenir un revêtement de protection 12 avec un indice de réfraction effectif correspondant le plus précisément possible à celui du substrat 11, avec une grande capacité d'adaptation et de façon relativement simple, en ajustant les rapports entre les différents composés constituant le revêtement de protection 12.

L'étape de dépôt d'un revêtement de protection 12 est mise en œuvre préférentiellement par une méthode de dépôt physique en phase vapeur PVD, par exemple par évaporation à l'arc, ablation laser, pulvérisation par faisceau ionique ou évaporation par faisceau électron ou effet Joule, préférentiellement par pulvérisation cathodique, en atmosphère réactive ou non-réactive. Alternativement, l'étape de dépôt peut être réalisée par toute méthode de dépôt chimique en phase vapeur CVD ou de dépôt de couches atomiques ALD.

De manière plus générale, il est à noter que les modes de mise en œuvre et de réalisation considérés ci-dessus ont été décrits à titre d'exemples non limitatifs, et que d'autres variantes sont par conséquent envisageables.

Notamment, des matériaux différents de ceux mentionnés dans les variantes de mises en œuvre du procédé décrites ci-dessus peuvent être utilisés. En particulier, l'usage de sources de matériaux métalliques a été décrit mais il est envisageable d'utiliser des sources de matériaux non métalliques.

## Revendications

1. Pièce d'habillage (10) **caractérisée en ce qu'**elle comprend un substrat (11) réalisé en matériau céramique sur une surface duquel s'étend un revêtement de protection (12) inorganique transparent, ledit revêtement de protection (12) étant configuré de sorte à présenter un indice de réfraction sensiblement égal à celui du substrat (11) dans le domaine visible du spectre lumineux de sorte que la pièce d'habillage (10) présente une couleur sensiblement identique à la couleur intrinsèque du substrat (11), ledit revêtement (12) s'étendant sur une épaisseur choisie entre 300 nm et 5 µm.

2. Pièce d'habillage (10) selon la revendication 1, dans laquelle le revêtement de protection (12) est configuré de sorte qu'il confère à la pièce d'habillage (10) une couleur dont la différence avec la couleur intrinsèque du substrat (11) est **caractérisée par** Delta E ≤ 10 dans l'espace colorimétrique L*a*b*.

3. Pièce d'habillage (10) selon la revendication 2, dans laquelle le revêtement de protection (12) est configuré de sorte qu'il confère à la pièce d'habillage (10) une couleur dont la différence avec la couleur intrinsèque du substrat (11) est **caractérisée par** Delta E ≤ 5 dans l'espace colorimétrique L*a*b*.

4. Pièce d'habillage (10) selon l'une des revendications 1 à 3, dans laquelle l'épaisseur du revêtement de protection (12) est comprise entre 300 nm et 1 µm.

5. Pièce d'habillage (10) selon l'une des revendications 1 à 4, dans laquelle le revêtement de protection (12) est formé d'au moins deux composés présentant respectivement, pour les longueurs d'onde dans le domaine visible du spectre lumineux, un indice de réfraction supérieur à celui du substrat et un indice de réfraction inférieur à celui du substrat.

6. Pièce d'habillage (10) selon l'une des revendications 1 à 5, dans laquelle le revêtement de protection (12) comporte au moins une couche réalisée en TiₓAl_{y}O_{z}.

7. Pièce d'habillage (10) selon l'une des revendications 1 à 5, dans laquelle le revêtement de protection (12) comporte au moins une couche réalisée en SiₓO_{y}N_{z}.

8. Pièce d'habillage (10) selon l'une des revendications 1 à 6, dans laquelle le substrat (11) est réalisé en alumine Al₂O₃, en zircone ZrO₂ ou en composite alumine-zircone.

9. Procédé de fabrication d'une pièce d'habillage (10) comprenant les étapes de :
- préparation d'une surface d'un substrat (11), et de
- dépôt d'un revêtement de protection (12) inorganique transparent sur ladite surface par une méthode de dépôt sous vide ;
le procédé étant **caractérisé en ce que** ladite étape de dépôt est réalisée à partir d'au moins une source d'au moins un matériau choisi de sorte que le revêtement de protection (12) présente un indice de réfraction sensiblement égal à celui du substrat (11) dans le domaine visible du spectre lumineux, ladite étape étant en outre réalisée de sorte que le revêtement de protection (12) présente une épaisseur comprise entre 300 nm et 5 µm.

10. Procédé de fabrication selon la revendication 9, dans lequel l'étape de dépôt d'un revêtement de protection (12) est réalisée par méthode de pulvérisation cathodique.

11. Procédé de fabrication selon la revendication 9 ou 10, dans lequel le revêtement de protection (12) est déposé à partir d'au moins deux sources de matériaux différents, lesdits matériaux étant choisis de sorte que lors de l'étape de dépôt, ils forment chacun un composé présentant, dans le domaine visible du spectre lumineux, respectivement un indice de réfraction supérieur à celui du substrat (11) et un indice de réfraction inférieur à celui du substrat (11), la puissance de pulvérisation de chacune des sources étant contrôlée de sorte que les proportions de chaque composé dans le revêtement de protection (12) sont telles que ledit revêtement présente un indice de réfraction sensiblement identique à celui du substrat (11).

12. Procédé de fabrication selon la revendication 9 ou 10, dans lequel le revêtement de protection (12) est déposé à partir d'au moins une source d'un mélange de matériaux, lesdits matériaux étant choisis de sorte que lors de l'étape de dépôt, ils forment chacun un composé présentant, dans le domaine visible du spectre lumineux, respectivement un indice de réfraction supérieur à celui du substrat (11) et un indice de réfraction inférieur à celui du substrat (11), ladite source étant préparée de sorte à comporter des proportions prédéfinies desdits matériaux de sorte que le revêtement de protection 12 présente, à l'issue de l'étape de dépôt, un indice de réfraction sensiblement identique à celui du substrat (11).

13. Procédé de fabrication selon la revendication 11 ou 12, dans lequel les matériaux choisis sont de l'Al et du Ti, l'étape de dépôt étant mise en œuvre en utilisant de l'O₂ comme gaz réactif de sorte qu'à l'issue de l'étape de dépôt, le revêtement de protection (12) comprenne un mélange de TiO₂ et d'Al₂O₃ de sorte à former un composé du type TiₓAl_{y}O_{z}.

14. Procédé de fabrication selon la revendication 9 ou 10, dans lequel le revêtement de protection (12) est déposé à partir d'au moins une source d'un unique matériau choisi de sorte que, lors de l'étape de dépôt, il forme plusieurs composés en réagissant avec plusieurs gaz réactifs en présence, lesdits composés présentant, dans le domaine visible du spectre lumineux, respectivement un indice de réfraction supérieur à celui du substrat (11) et un indice de réfraction inférieur à celui du substrat (11), les gaz réactifs étant présents dans des proportions prédéfinies de sorte que le revêtement de protection (12) présente, à l'issue de l'étape de dépôt, un indice de réfraction sensiblement identique à celui du substrat (11).

15. Procédé de fabrication selon la revendication 14, dans lequel l'étape de dépôt est effectuée à partir d'une source réalisée en Si et en utilisant de l'O₂ et de l'N₂ comme gaz réactifs de sorte qu'à l'issue de l'étape de dépôt, le revêtement de protection (12) comprenne un mélange de SiO₂ et de Si₃N₄ de sorte à former un composé du type SiₓO_{y}N_{z}.

## Patentansprüche

1. Verkleidungsstück (10), **dadurch gekennzeichnet, dass** es ein Substrat (11) aus keramischem Werkstoff umfasst, auf dessen Oberfläche sich eine transparente anorganische Schutzbeschichtung (12) erstreckt, wobei die Schutzbeschichtung (12) so ausgelegt ist, dass sie im sichtbaren Bereich des Lichtspektrums einen Brechungsindex aufweist, der im Wesentlichen demjenigen des Substrats (11) entspricht, so dass das Verkleidungsstück (10) eine Farbe aufweist, die im Wesentlichen mit der intrinsischen Farbe des Substrats (11) identisch ist, wobei die Schutzbeschichtung (12) eine Dicke aufweist, die zwischen 300 nm und 5 pm gewählt ist.

2. Verkleidungsstück (10) nach Anspruch 1, wobei die Schutzbeschichtung (12) so ausgelegt ist, dass sie dem Verkleidungsstück (10) eine Farbe verleiht, deren Farbunterschied zur intrinsischen Farbe des Substrats (11) durch einen Farbunterschied ΔE < 10 im L*a*b*-Farbraum gekennzeichnet ist.

3. Verkleidungsstück (10) nach Anspruch 2, wobei die Schutzbeschichtung (12) so ausgelegt ist, dass sie dem Verkleidungsstück (10) eine Farbe verleiht, deren Farbunterschied zur intrinsischen Farbe des Substrats (11) durch einen Farbunterschied ΔE < 5 im L*a*b*-Farbraum gekennzeichnet ist.

4. Verkleidungsstück (10) nach einem der Ansprüche 1 bis 3, wobei die Dicke der Schutzbeschichtung (12) zwischen 300 nm und 1 pm liegt.

5. Verkleidungsstück (10) nach einem der Ansprüche 1 bis 4, wobei die Schutzbeschichtung (12) aus mindestens zwei Verbindungen gebildet ist, die für die Wellenlängen im sichtbaren Bereich des Lichtspektrums jeweils einen Brechungsindex aufweisen, von denen der eine größer ist als der Brechungsindex des Substrats und der andere kleiner ist als der Brechungsindex des Substrats.

6. Verkleidungsstück (10) nach einem der Ansprüche 1 bis 5, wobei die Schutzbeschichtung (12) mindestens eine aus TiₓAl_{y}O_{z} ausgebildete Schicht umfasst.

7. Verkleidungsstück (10) nach einem der Ansprüche 1 bis 5, wobei die Schutzbeschichtung (12) mindestens eine aus SiₓO_{y}N_{z} ausgebildete Schicht umfasst.

8. Verkleidungsstück (10) nach einem der Ansprüche 1 bis 6, wobei das Substrat (11) aus Aluminiumoxid Al₂O₃, Zirkonoxid ZrO₂ oder aus einem Aluminiumoxid-Zirkonoxid -Verbundwerkstoff hergestellt ist.

9. Herstellungsverfahren für ein Verkleidungsstück (10), umfassend die Schritte:
- Vorbereiten einer Oberfläche eines Substrats (11) und
- Abscheiden einer transparenten anorganischen Schutzbeschichtung (12) auf der genannten Oberfläche mittels eines Vakuumabscheidungsverfahrens;
wobei das Verfahren **dadurch gekennzeichnet ist, dass** der genannte Abscheideschritt ausgehend von mindestens einer Quelle von mindestens einem ausgewählten Material durchgeführt wird, so dass die Schutzbeschichtung (12) im sichtbaren Bereich des Lichtspektrums einen Brechungsindex aufweist, der im Wesentlichen dem Brechungsindex des Substrats (11) entspricht, und dass der genannte Schritt ferner so durchgeführt wird, dass die Schutzbeschichtung (12) eine Dicke zwischen 300 nm und 5 pm aufweist.

10. Herstellungsverfahren nach Anspruch 9, bei dem der Schritt des Abscheidens einer Schutzbeschichtung (12) mittels eines Kathodenzerstäubungsverfahrens durchgeführt wird.

11. Herstellungsverfahren nach Anspruch 9 oder 10, bei dem die Schutzbeschichtung (12) ausgehend von mindestens zwei Quellen unterschiedlicher Materialien abgeschieden wird, wobei diese Materialien so ausgewählt sind, dass sie während des Abscheideschritts jeweils eine Verbindung bilden, die im sichtbaren Bereich des Lichtspektrums einen Brechungsindex aufweist, der im Falle der einen Verbindung größer ist als der Brechungsindex des Substrats (11) und im Falle der anderen Verbindung kleiner ist als der Brechungsindex des Substrats (11), wobei die Sputterleistung jeder der Quellen so gesteuert wird, dass die Anteile jeder Verbindung in der Schutzbeschichtung (12) derart sind, dass die Schutzbeschichtung einen Brechungsindex aufweist, der im Wesentlichen mit dem des Substrats (11) identisch ist.

12. Herstellungsverfahren nach Anspruch 9 oder 10, bei dem die Schutzbeschichtung (12) ausgehend von mindestens einer Quelle eines Materialgemisches abgeschieden wird, wobei diese Materialien so ausgewählt sind, dass sie während des Abscheideschritts jeweils eine Verbindung bilden, die im sichtbaren Bereich des Lichtspektrums einen Brechungsindex aufweist, der im Falle der einen Verbindung größer ist als der Brechungsindex des Substrats (11) und im Falle der anderen Verbindung kleiner ist als der Brechungsindex des Substrats (11), und wobei die genannte Quelle so vorbereitet ist, dass sie vorbestimmte Anteile der genannten Materialien enthält, so dass die Schutzbeschichtung (12) am Ende des Abscheideschritts einen Brechungsindex aufweist, der im Wesentlichen mit dem des Substrats (11) identisch ist.

13. Herstellungsverfahren nach Anspruch 11 oder 12, wobei die ausgewählten Materialien Al und Ti sind, wobei der Abscheideschritt unter Verwendung von O₂ als reaktivem Gas durchgeführt wird, so dass die Schutzbeschichtung (12) am Ende des Abscheideschritts ein Gemisch aus TiO₂ und Al₂O₃ umfasst, so dass eine Verbindung des Typs TiₓAl_{y}O_{z} gebildet wird.

14. Herstellungsverfahren nach Anspruch 9 oder 10, bei dem die Schutzbeschichtung (12) ausgehend von mindestens einer Quelle eines einzigen ausgewählten Materials abgeschieden wird, wobei dieses Material während des Abscheideschritts durch Reaktion mit mehreren vorhandenen reaktiven Gasen mehrere Verbindungen bildet, die im sichtbaren Bereich des Lichtspektrums jeweils einen Brechungsindex aufweisen, von denen der eine größer ist als der Brechungsindex des Substrats (11) und der andere kleiner ist als der Brechungsindex des Substrats (11), wobei die reaktiven Gase in vorbestimmten Anteilen vorhanden sind, so dass die Schutzbeschichtung (12) am Ende des Abscheideschritts einen Brechungsindex aufweist, der im Wesentlichen mit dem des Substrats (11) identisch ist.

15. Herstellungsverfahren nach Anspruch 14, bei dem der Abscheideschritt ausgehend von einer Quelle aus Si und unter Verwendung von O2 und N2 als reaktive Gase durchgeführt wird, so dass die Schutzbeschichtung (12) am Ende des Abscheideschritts ein Gemisch aus SiO₂ und Si₃N₄ umfasst, so dass eine Verbindung des Typs SiₓO_{y}N_{z} gebildet wird.

## Claims

1. An external part (10), **characterised in that** it comprises a substrate (11) made of ceramic material on a surface of which extends a transparent inorganic protective coating (12), said protective coating (12) being configured so as to have a refractive index substantially equal to that of the substrate (11) in the visible range of the light spectrum, so that the external part (10) has a colour substantially identical to the intrinsic colour of the substrate (11), said coating (12) extending over a thickness chosen between 300 nm and 5 µm.

2. The external part (10) according to claim 1, wherein the protective coating (12) is configured so that it imparts to the external part (10) a colour whose difference from the intrinsic colour of the substrate (11) is **characterised by** Delta E ≤ 10 in the L*a*b* colour space.

3. The external part (10) according to claim 2, wherein the protective coating (12) is configured so that it imparts to the external part (10) a colour whose difference from the intrinsic colour of the substrate (11) is **characterised by** Delta E ≤ 5 in the L*a*b* colour space.

4. The external part (10) according to one of claims 1 to 3, wherein the thickness of the protective coating (12) is comprised between 300 nm and 1 µm.

5. The external part (10) according to one of claims 1 to 4, wherein the protective coating (12) is formed of at least two compounds having respectively, for wavelengths in the visible range of the light spectrum, a refractive index greater than that of the substrate and a refractive index less than that of the substrate.

6. The external part (10) according to one of claims 1 to 5, wherein the protective coating (12) includes at least one layer made of TiₓAl_{y}O_{z}.

7. The external part (10) according to one of claims 1 to 5, wherein the protective coating (12) includes at least one layer made of SiₓO_{y}N_{z}.

8. The external part (10) according to one of claims 1 to 6, wherein the substrate (11) is made of alumina Al₂O₃, zirconia ZrO₂ or an alumina-zirconia composite.

9. A method for manufacturing an external part (10) comprising the steps of:
- preparing a surface of a substrate (11), and of
- depositing a transparent inorganic protective coating (12) on said surface by a vacuum deposition method;
the method being **characterised in that** said deposition step is carried out from at least one source of at least one material chosen so that the protective coating (12) has a refractive index substantially equal to that of the substrate (11) in the visible range of the light spectrum, said step also being carried out so that the protective coating (12) has a thickness comprised between 300 nm and 5 µm.

10. The manufacturing method as claimed in claim 9, wherein the step of depositing a protective coating (12) is carried out by cathodic sputtering method.

11. The manufacturing method according to claim 9 or 10, wherein the protective coating (12) is deposited from at least two sources of different materials, said materials being chosen so that, during the deposition step, they each form a compound having, in the visible range of the light spectrum, respectively a refractive index greater than that of the substrate (11) and a refractive index less than that of the substrate (11), the sputtering power of each of the sources being controlled so that the proportions of each compound in the protective coating (12) are such that said coating has a refractive index substantially identical to that of the substrate (11).

12. The manufacturing method according to claim 9 or 10, wherein the protective coating (12) is deposited from at least one source of a mixture of materials, said materials being chosen so that, during the deposition step, they each form a compound having, in the visible range of the light spectrum, respectively a refractive index greater than that of the substrate (11) and a refractive index lower than that of the substrate (11), said source being prepared so as to include predefined proportions of said materials so that the protective coating 12 has, at the end of the deposition step, a refractive index substantially identical to that of the substrate (11).

13. The manufacturing method according to claim 11 or 12, wherein the materials chosen are Al and Ti, the deposition step being carried out using O₂ as the reactive gas so that, at the end of the deposition step, the protective coating (12) comprises a mixture of TiO₂ and Al₂O₃ so as to form a compound of the type TiₓAl_{y}O_{z}.

14. The manufacturing method according to claim 9 or 10, wherein the protective coating (12) is deposited from at least one source of a single material chosen so that, during the deposition step, it forms several compounds by reacting with several reactive gases present, said compounds having, in the visible range of the light spectrum, respectively a refractive index greater than that of the substrate (11) and a refractive index lower than that of the substrate (11), the reactive gases being present in predefined proportions so that, at the end of the deposition step, the protective coating (12) has a refractive index substantially identical to that of the substrate (11).

15. The manufacturing method according to claim 14, wherein the deposition step is carried out from a source made of Si and using O₂ and N₂ as reactive gases so that, at the end of the deposition step, the protective coating (12) comprises a mixture of SiO₂ and Si₃N₄ so as to form a compound of the type SiₓO_{y}N_{z}.
